# EUROPEAN PATENT APPLICATION

(11) **EP 4 753 411 A1**
(43) Date of publication of application: **03.06.2026**
(21) Application number: 25199274.9
(22) Date of filing: 01.09.2025
(51) Int. Cl.: H10H 20/01, H10H 20/857, H10H 29/20

(54) **WAFER WITH LIGHT EMITTING ELEMENTS, METHOD OF INSPECTING LIGHT EMITTING ELEMENTS, AND METHOD OF MANUFACTURING LIGHT EMITTING ELEMENTS**

(30) Priority: 29.11.2024 KR 20240174963
(71) Applicant: LG Display Co., Ltd., Seoul, 07336 (KR)
(72) Inventor: KIM, Il-Soo, 10845 Paju-si (KR); KWAK, YongSeok, 10845 Paju-si (KR); HAN, Myungsoo, 10845 Paju-si (KR)
(74) Representative: Ter Meer Steinmeister & Partner

(57) **Abstract**

According to an aspect of the present disclosure, a wafer with light emitting elements, a method of inspecting light emitting elements, and a method of manufacturing light emitting elements are provided. The wafer includes a substrate, a plurality of light emitting elements above the substrate, a connector above the substrate and connected between the plurality of light emitting elements, and a support between the connector and the substrate. The plurality of light emitting elements are spaced apart from the substrate. Accordingly, the plurality of light emitting elements may be easily separated from the substrate individually in a subsequent process.

## Description

This application claims the priority of Korean Patent Application No. 10-2024-0174963, filed on November 29, 2024.

### TECHNICAL FIELD

The present disclosure relates to a wafer with light emitting elements, a method of inspecting light emitting elements, and a method of manufacturing light emitting elements. More particularly, the present disclosure relates to a wafer with light emitting elements on which an efficient inspection process is possible, and methods of inspecting and manufacturing such light emitting elements.

### BACKGROUND

Display devices used for a monitor of a computer, a television, or a cellular phone include, among others, an organic light emitting display (OLED) device, which is a self-emitting device, and a liquid crystal display (LCD) device, which requires a separate light source.

As applications for display devices are becoming more diversified, for example, from personal digital assistants to monitors of computers and televisions, a display device with a large display area and reduced volume and weight is being studied.

Further, in recent years, a display device including a light emitting diode (LED) is attracting attention as a next generation display device. Since the LED is formed of an inorganic material, rather than an organic material, its reliability is excellent so that its lifespan is longer than that of the liquid crystal display device or the organic light emitting display device. Further, the LED has a relatively fast lighting speed, excellent luminous efficiency, and a strong impact resistance so that its stability is excellent, and an image having a high luminance can be displayed.

### SUMMARY

An object of the present disclosure is to provide a wafer with light emitting elements on which a rapid inspection process is possible, a method of inspecting such light emitting elements, and a method of manufacturing such light emitting elements.

Another object of the present disclosure is to provide a wafer with light emitting elements on which a defect inspection is possible with a probe card with a simplified structure and a method of manufacturing such light emitting elements.

Still another object of the present disclosure is to provide a wafer on which only a defective light emitting element, among a plurality of light emitting elements, can be simply removed, a method of inspecting such light emitting elements, and a method of manufacturing such light emitting elements.

Objects of the present disclosure are not limited to the above-mentioned objects, and other objects, which are not mentioned above, can be clearly understood by those skilled in the art from the following descriptions. At least one of these objects is solved by the features of the independent claims.

According to one aspect of the present disclosure, a wafer includes a substrate, a plurality of light emitting elements above/on the substrate, a connector above/on the substrate and connected between the plurality of light emitting elements, and a support between the connector and the substrate, wherein the plurality of light emitting elements are spaced apart from the substrate. Accordingly, the plurality of light emitting elements may easily be separated from the substrate individually in a subsequent process.

According to an aspect of the present disclosure, a method of inspecting a plurality of light emitting elements, e.g. on a wafer, includes: preparing a wafer on which the plurality of light emitting elements are formed (e.g., a wafer according to any one of the herein described aspects and embodiments) and inspecting the plurality of light emitting elements by contacting the wafer with a probe card. The inspecting of the plurality of light emitting elements includes contacting a common inspection electrode and individual electrodes of the plurality of light emitting elements respectively with a plurality of pin electrodes of the probe card. Accordingly, a voltage may be simultaneously applied to the plurality of light emitting elements by means of the common inspection electrode so that the inspection time may be shortened.

In yet another aspect of the present disclosure, a method of manufacturing a plurality of light emitting elements, e.g. on a wafer, in particular on a wafer according to any one of the herein described aspects and embodiments), includes: forming an epi layer including a buffer layer on a substrate, forming the plurality of light emitting elements and a connector by etching the epi layer, and forming a porous area (or gap area) under the plurality of light emitting elements and forming a support under the connector by etching the buffer layer.

Other detailed matters of various example embodiments are included in the detailed description and the drawings.

According to example embodiments of the present disclosure, a gap area may be formed between the light emitting elements and the substrate so that the light emitting elements may be relatively easily separated from the substrate in a subsequent process.

According to example embodiments of the present disclosure, the plurality of light emitting elements may share one common inspection electrode so that the plurality of light emitting elements can be simultaneously inspected.

According to example embodiments of the present disclosure, the plurality of light emitting elements can be simultaneously inspected so that an inspection time of the plurality of light emitting elements can be reduced.

According to example embodiments of the present disclosure, a buffer layer below the light emitting elements and a connection unit (or connector) may be partially or selectively etched using a photoresist pattern to form a support unit (or support) and a porous structure which allow the light emitting elements to be easily and individually separated from the substrate.

The effects according to the present disclosure are not limited to the contents exemplified above, and various additional effects may be attained from the present disclosure.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a plan view of a wafer according to an example embodiment of the present disclosure;
FIG. 2 is a cross-sectional view taken along A-A' in FIG. 1;
FIG. 3 is a cross-sectional view taken along B-B' in FIG. 1;
FIGs. 4A and 4B illustrate a method of inspecting a light emitting element according to an example embodiment of the present disclosure; and
FIGs. 5A to 5H are process diagrams for explaining a method of manufacturing a light emitting element according to an example embodiment of the present disclosure.

### DETAILED DESCRIPTION

Advantages and characteristics of the present disclosure and a method of achieving the advantages and characteristics will be clear by referring to example embodiments described below in detail together with the accompanying drawings. However, the present disclosure is not limited to the example embodiments disclosed herein and may be implemented in various other forms. The example embodiments are provided by way of example only so that those skilled in the art can more fully understand the features and aspects of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure.

Such terms as "including," "having," and "consist of," where used herein, are generally intended to allow other components to be added unless the terms are used with a more limiting term like "only." Any references to singular may include plural, and vice versa, unless expressly stated otherwise.

Components are to be interpreted to include an ordinary error range even if not expressly stated.

Where the position relation between two parts is described using such terms as "on," "above," "below," and "next," one or more parts may be positioned between the two parts unless the terms are used with a more limiting term like "immediately" or "directly."

Where an element or layer is described as being disposed "on" one other element or layer, the element or layer may be disposed directly on the one other element or layer, or an additional layer or element may be interposed therebetween.

Although the terms "first," "second," and the like may be used for describing various components, these components are not confined by these terms. These terms are merely used to refer to one component separately from the other components. Therefore, a first component to be mentioned below may be a second component, and vice versa, in a technical concept of the present disclosure.

Like reference numerals generally denote like elements throughout the specification unless otherwise specified.

A size and a thickness of each component illustrated in the drawing are illustrated for convenience of description, and the present disclosure is not limited to the size and the thickness of the component illustrated.

The features of various example embodiments of the present disclosure can be partially or entirely adhered to or combined with each other and can be interlocked and operated in technically various ways, and the example embodiments can be carried out independently of or in association with each other.

Hereinafter, example embodiments of the present disclosure will be described in detail with reference to accompanying drawings.

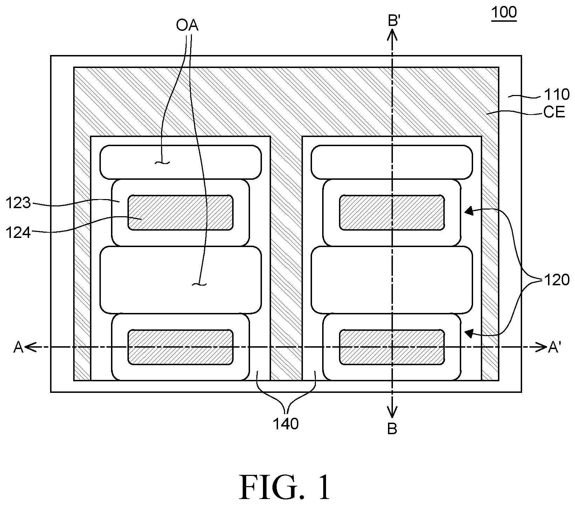

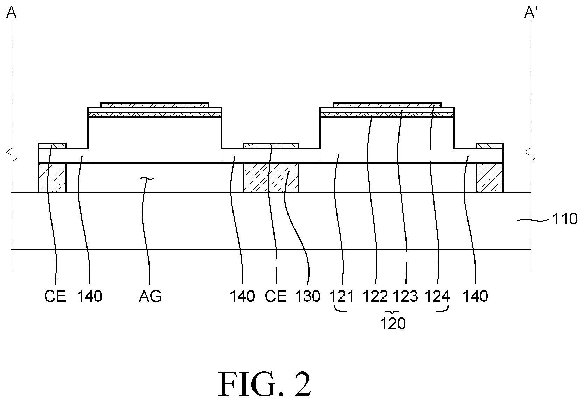

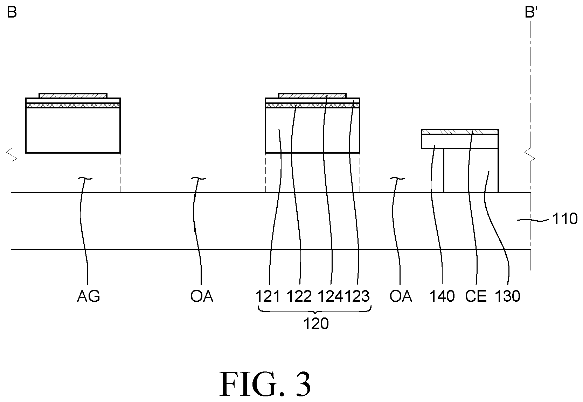

FIG. 1 is a plan view of a wafer according to an example embodiment of the present disclosure. FIG. 2 is a cross-sectional view taken along A-A' in FIG. 1. FIG. 3 is a cross-sectional view taken along B-B' in FIG. 1.

As illustrated in FIGs. 1 to 3, a wafer 100 is a member on which a plurality of light emitting elements 120 are formed. The wafer 100 includes a substrate 110, a connection unit (or connector) 140, and a plurality of light emitting elements 120.

First, the substrate 110 is a substrate 110 on which the plurality of light emitting elements 120 are grown. The substrate 110 may be formed of various materials depending on a type of a semiconductor material to configure the plurality of light emitting elements 120. For example, the substrate 110 may be formed of sapphire, gallium nitride (GaN), silicon (Si), or silicon carbide (SiC), but is not limited thereto.

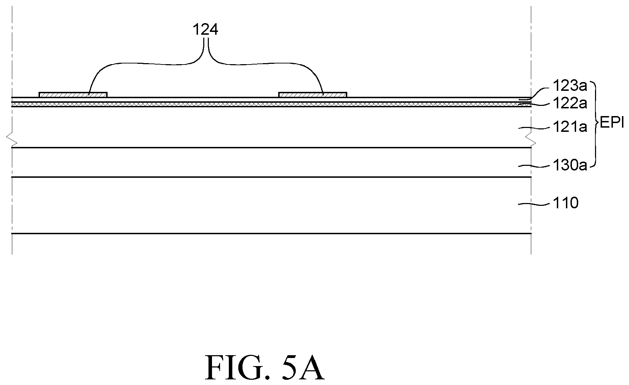

The plurality of light emitting elements 120 are disposed on the substrate 110. The light emitting elements 120 are semiconductor elements which emit light when a current is applied. The light emitting elements 120 may be light-emitting diodes (LED) or micro light-emitting diode (micro LEDs), but the example embodiments of the present disclosure are not limited thereto. After forming an epi layer EPI by growing a semiconductor material, such as gallium nitride (GaN), on the substrate 110, the epi layer is etched into a plurality of pieces to form the plurality of light emitting elements 120. A detailed description for a method of manufacturing the plurality of light emitting elements 120 will be provided below with reference to FIGs. 5A to 5H.

Each of the plurality of light emitting elements 120 includes a first semiconductor layer 121, an emission layer 122, a second semiconductor layer 123, and an individual electrode 124.

The first semiconductor layer 121 of each of the plurality of light emitting elements 120 is disposed on the substrate 110, and the second semiconductor layer 123 is disposed on the first semiconductor layer 121. Any one of the first semiconductor layer 121 and the second semiconductor layer 123 is a semiconductor layer doped with an n-type impurity, and the other is a semiconductor layer doped with a p-type impurity. For example, the first semiconductor layer 121 and the second semiconductor layer 123 may be semiconductor layers doped with n-type or p-type impurities into a host material, such as gallium nitride (GaN), indium aluminum phosphide (InAlP), or gallium arsenide (GaAs). The p-type impurity may be magnesium (Mg), zinc (Zn), or beryllium (Be), and the n-type impurity may be silicon (Si), germanium, or tin (Sn), but are not limited thereto.

The emission layer 122 is disposed between the first semiconductor layer 121 and the second semiconductor layer 123. The emission layer 122 emits light based on a current supplied to the light emitting element 120. For example, the emission layer 122 may be formed by a single layer or a multi-quantum well (MQW) structure, and for example, may be formed of indium gallium nitride (InGaN) or gallium nitride (GaN), but is not limited thereto.

The individual electrode 124 is disposed on the second semiconductor layer 123. The individual electrode 124 may be configured by a transparent conductive material, such as indium tin oxide (ITO) or indium zinc oxide (IZO), but is not limited thereto.

The connection unit 140 is disposed between the plurality of light emitting elements 120. The connection unit (or connector) 140 is a part which connects the plurality of first semiconductor layers 121 with each other and may be integrally formed with the plurality of first semiconductor layers 121. For example, the connection unit 140 may extend the first semiconductor layer 121 of a respective adjacent light emitting element 120 from each of the plurality of first semiconductor layers 121. The connection unit 140 may be disposed so as to enclose each of the plurality of first semiconductor layers 121 in a plan view. The plurality of first semiconductor layers 121 may be connected to each other by the connection unit 140.

A support unit (or support) 130 may be disposed between the connection unit 140 and the substrate 110. The support unit 130 supports the connection unit 140 to maintain the connection unit 140 spaced apart from the substrate 110 so that the plurality of light emitting elements 120 are also spaced apart from the substrate 110. The support unit 130 may be formed from a buffer layer 130a, among a plurality of layers which forms the epi layer EPI (see, e.g., FIGs. 5A to 5H).

A gap area AG, which is an empty area, may be formed below the plurality of light emitting elements 120 which are spaced apart from the substrate 110 by the support unit 130 and the connection unit 140. That is, the plurality of light emitting elements 120 and the connection unit 140 may be floated above the substrate 110, by the support unit 130 so that the gap area AG, which is an empty space, is formed between the plurality of light emitting elements 120 and the substrate 110. The gap area AG may be an air-filled gap. The gap area AG may be denoted as gap or air gap AG or as porous area.

As shown in FIG. 2, a width of the connection unit 140 may be larger than a width of the support unit 130. The connection unit 140 may be configured by a part overlapping the support unit 130 and a part overlapping the gap area AG. A thickness of the connection unit 140 may be smaller than a thickness of the first semiconductor layer 121. In this case, the light emitting element 120 may be separated from the substrate 110 by cutting the part of the connection unit 140 which overlaps the gap area AG. Further, the thickness of the connection unit 140 is formed to be smaller than that of the first semiconductor layer 121 so that the part of the connection unit 140 overlapping the gap area AG may be more easily cut. Accordingly, when the light emitting element 120 is separated from the substrate 110, the connection unit 140 is cut to separate the light emitting element 120 from the connection unit 140, the support unit 130, and the substrate 110.

A common inspection electrode CE may be disposed on the connection unit 140. The common inspection electrode CE is electrically connected to the first semiconductor layers 121 of the plurality of light emitting elements 120 through the connection unit 140. The plurality of light emitting elements 120 may share one common inspection electrode CE. The common inspection electrode CE is a temporary electrode used to inspect the light emitting elements 120. The common inspection electrode CE may be separated from the light emitting elements 120 after completing the inspection process of the light emitting elements 120. For example, the common inspection electrode CE may be formed of an opaque conductive material, such as titanium (Ti), gold (Au), silver (Ag), copper (Cu), or an alloy thereof, but is not limited thereto.

As illustrated in FIGs. 1 and 3, a plurality of openings OA may be disposed in an area between light emitting elements 120. The plurality of openings OA may be formed in the connection unit 140 and the buffer layer 130a. At least one of the plurality of light emitting elements 120 may be disposed between one pair of openings OA. Some of the edges of the light emitting element 120 may border the opening(s) OA, and the other edges may be connected to the connection unit 140. The plurality of openings OA is connected to the gap area AG.

The plurality of openings OA is provided to form the gap area AG below the light emitting element 120 while manufacturing the plurality of light emitting elements 120. An etchant for etching the buffer layer 130a is injected through the plurality of openings OA to form the gap area AG, which will be described in more detail below with reference to FIGs. 5A to 5H.

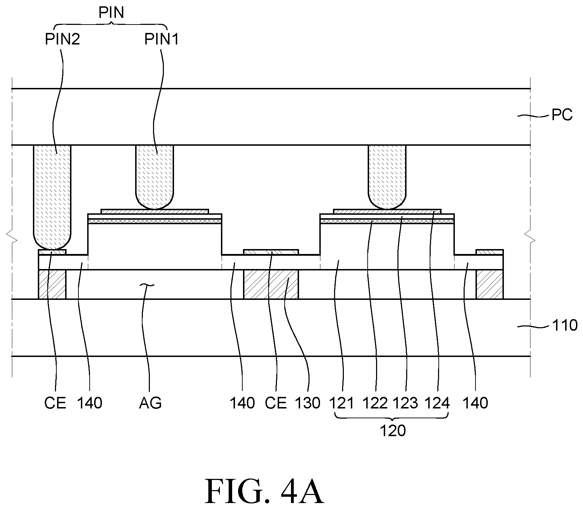

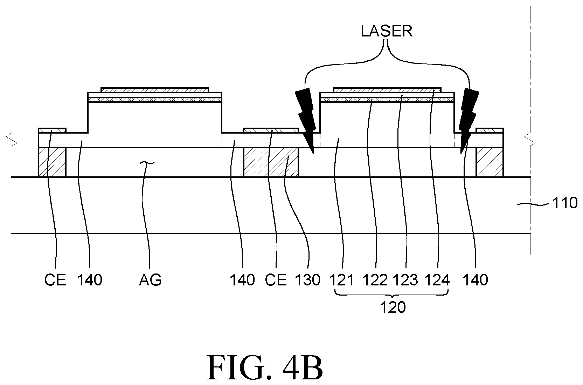

FIGs. 4A and 4B illustrate a method of inspecting a light emitting element according to an example embodiment of the present disclosure. FIGs. 4A and 4B illustrate this example method based on the cross-sectional view of FIG. 2 (i.e., along line A-A' in FIG. 1).

As shown in FIG. 4A, a probe card PC is a member for detecting a non-lighting defect of the plurality of light emitting elements 120. For example, the probe card PC supplies a current to the plurality of light emitting elements 120 to detect a defective light emitting element 120 which does not light up.

The probe card PC includes a plurality of pin electrodes PIN. The plurality of pin electrodes PIN are electrodes which supply currents to the plurality of light emitting elements 120 and include a plurality of first pin electrodes PIN1 and a second pin electrode PIN2.

The plurality of first pin electrodes PIN1 are electrodes to be in contact respectively with the individual electrodes 124 of the plurality of light emitting elements 120. The plurality of first pin electrodes PIN1 apply a voltage to the plurality of individual electrodes 124.

The second pin electrode PIN2 is an electrode to be in contact with the common inspection electrode CE. The second pin electrode PIN2 applies a voltage to the common inspection electrode CE, and the voltage applied from the second pin electrode PIN2 is applied to each of the plurality of first semiconductor layers 121 through the common inspection electrode CE and the connection unit 140. Even though one second pin electrode PIN2 is illustrated in FIG. 4A, but the second pin electrode is not limited thereto. For example, a plurality of second pin electrodes PIN2 may also be provided.

When the plurality of light emitting elements 120 are inspected, the plurality of pin electrodes PIN of the probe card PC may be in contact with the common inspection electrode CE and the individual electrodes 124 of the light emitting elements 120 on the wafer 100, respectively. A current flows into the plurality of light emitting elements 120 by electrical signals which are applied respectively to the common inspection electrode CE and the individual electrodes 124 from the plurality of pin electrodes PIN, and the plurality of light emitting elements 120 should light up. Accordingly, the current is supplied to the plurality of light emitting elements using the probe card PC to detect a defective light emitting element 120 which does not light up.

As illustrated in FIG. 4B, when a defective light emitting element 120 which does not light up is detected, only the defective light emitting element 120 may easily be removed. For example, if a light emitting element 120 on a right side in FIG. 4B is defective, the connection unit (or connector) 140 which supports the light emitting element 120 on the right side can be cut with laser LASER, and the defective light emitting element 120 can be separated from the substrate 110. Accordingly, the part of the connection unit 140 which overlaps the gap area AG can be irradiated with laser LASER to cut the connection unit 140 to easily separate and remove the defective light emitting element 120 from the substrate 110.

According to the method of inspecting light emitting elements 120 according to the example embodiment of the present disclosure, the plurality of light emitting elements 120 share one common inspection electrode CE to easily light up the plurality of light emitting elements 120 and shorten an inspection time. For example, the voltage can simultaneously be applied to the first semiconductor layers 121 of the plurality of light emitting elements 120 by means of the common inspection electrode CE to simultaneously light up the plurality of light emitting elements 120 more easily. Therefore, the plurality of light emitting elements 120 can be simultaneously lit up to perform the inspection process at one time, and the inspection time can be shortened.

According to the method of inspecting light emitting elements 120 according to the example embodiment of the present disclosure, the plurality of light emitting elements 120 share one common inspection electrode CE to decrease the number of pin electrodes PIN of the probe card PC for lighting up the plurality of light emitting elements 120. For example, if the plurality of light emitting elements 120 do not share one common inspection electrode CE, but instead include separate inspection electrodes, a number of pin electrodes PIN for lighting up the plurality of light emitting elements 120 may be increased. In contrast, according to the method of inspecting light emitting elements 120 according to the example embodiment of the present disclosure, the inspection process can be performed with only a plurality of first pin electrodes PIN1 which are in contact respectively with the plurality of light emitting elements 120 and one second pin electrode PIN2 which are in contact with the common inspection electrode CE. Accordingly, the structure of the probe card PC can be simplified.

According to the method of inspecting light emitting elements 120 according to the example embodiment of the present disclosure, only a defective light emitting element 120, among the plurality of light emitting elements 120 of the wafer 100, can be selectively removed, and the defective light emitting element 120 can be prevented suppressed from being incorporated in the display device. For example, the plurality of light emitting elements 120 disposed on the wafer 100 can be simultaneously inspected to detect any defective light emitting element 120. A part of the connection unit 140 which supports the defective light emitting element 120 can be irradiated with the laser LASER to cut the connection unit 140 so that the defective light emitting element 120 can be easily removed from the wafer 100. Accordingly, after removing the defective light emitting element 120 by performing the inspection process in a state in which the plurality of light emitting elements 120 are disposed on the wafer 100, the remaining normal light emitting elements 120 can be transferred to the display device to be used. Accordingly, a potential transfer of any defective light emitting elements 120 to the display device can be minimized or suppressed, and a yield of a device which uses the light emitting elements 120 of the wafer 100 according to the example embodiment of the present disclosure may be improved.

Hereinafter, a method of manufacturing light emitting elements 120 will be described with reference to FIGs. 5A to 5H.

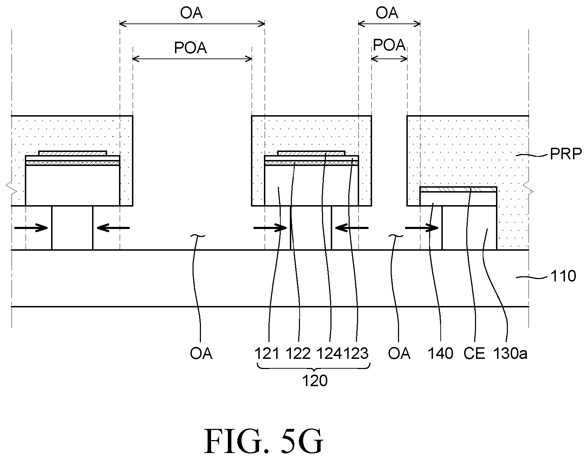

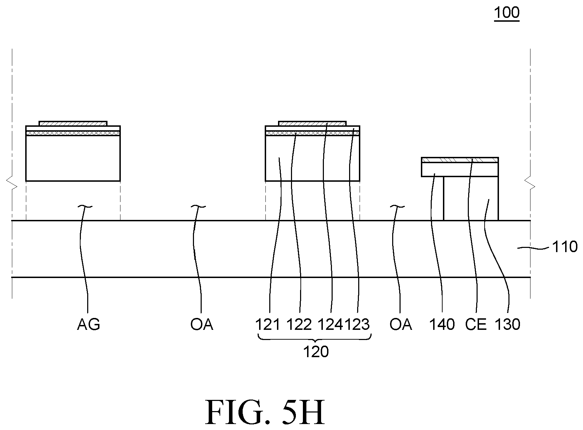

FIGs. 5A to 5H are process diagrams for explaining a method of manufacturing a light emitting element according to an example embodiment of the present disclosure. FIGs. 5A to 5E, 5G, and 5H are process diagrams illustrated based on the cross-sectional view of FIG. 3 (i.e., along line B-B' in FIG. 1).

As shown in FIG. 5A, an epi layer EPI is formed on a substrate 110. The epi layer EPI may include one or more semiconductor layers included in the plurality of light emitting elements 120 and is formed by growing a semiconductor crystal on the substrate 110.

The epi layer EPI may include a buffer layer 130a. The epi layer EPI may further include a first semiconductor material layer 121a, an emission material layer 122a, and a second semiconductor material layer 123a. The epi layer EPI may be formed by sequentially growing the buffer layer 130a, the first semiconductor material layer 121a, the emission material layer 122a, and the second semiconductor material layer 123a on the substrate 110.

The buffer layer 130a may be a layer formed of an undoped gallium nitride (un-GaN) and may be formed into a support unit (or support) 130 in a subsequent process. The first semiconductor material layer 121a is a layer which configures the first semiconductor layer 121 of the light emitting elements 120 and the connection unit (or connector) 140. The emission material layer 122a and the second semiconductor material layer 123a are layers which configure the emission layer 122 and the second semiconductor layer 123 of the light emitting elements 120, respectively.

Next, the individual electrode 124 of each of the plurality of light emitting elements 120 is formed on the epi layer EPI. Before etching the epi layer EPI, the individual electrodes 124 may first be formed on the epi layer EPI.

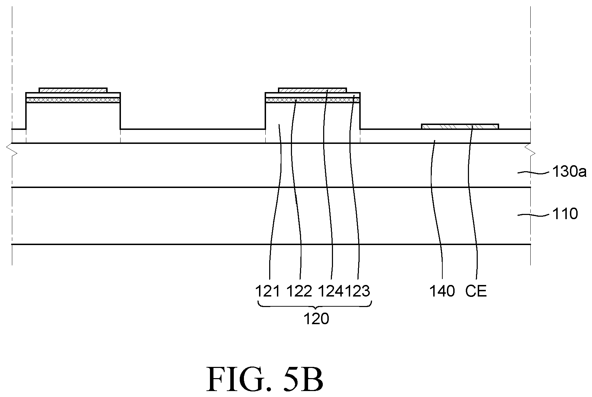

As shown in FIG. 5B, the epi layer EPI is mesa-etched. The epi layer EPI is etched in the form of the light emitting elements 120. For example, the second semiconductor material layer 123a and the emission material layer 122a are etched to form the plurality of second semiconductor layers 123 and the plurality of emission layers 122, respectively. The first semiconductor material layer 121a is etched to form the plurality of first semiconductor layers 121 and the connection unit 140. When the first semiconductor material layer 121a is etched, portions of the first semiconductor material layer 121a located in areas between the light emitting elements 120 are etched to a smaller thickness than the first semiconductor layers 121 to form the connection unit 140.

Next, the common inspection electrode CE is formed on the connection unit 140. The common inspection electrode CE is formed on the connection unit 140 so as to correspond to or overlap an area in which the support unit 130 is to be disposed.

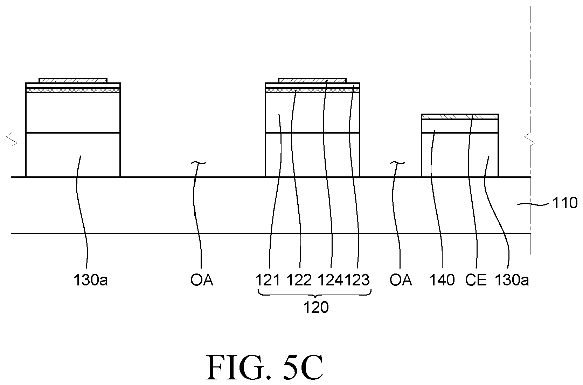

As illustrated in FIG. 5C, the plurality of openings OA may be formed in some of the areas between the plurality of light emitting elements 120. A part of the connection unit 140 and a part of the buffer layer 130a which would overlap the plurality of openings OA are etched to form the plurality of openings OA in these areas between the plurality of light emitting elements 120. Further, in the process of forming the plurality of openings OA, a remaining part of the epi layer EPI formed in areas other than areas where the light emitting elements 120, the support unit 130, and the connection unit 140 are disposed are also etched to be removed.

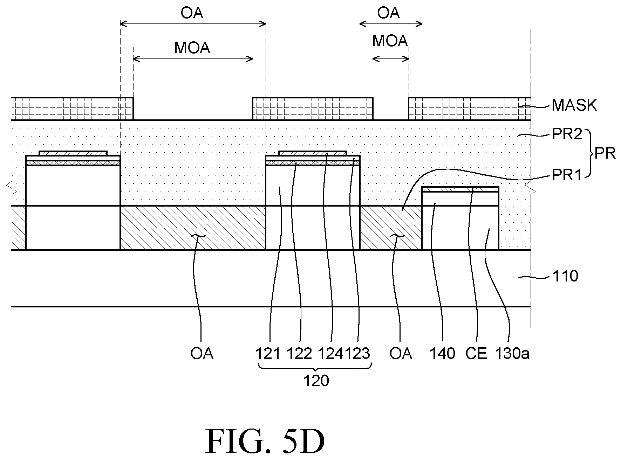

As shown in FIG. 5D, a photoresist PR is formed on the wafer 100 and is subject to the exposure. In the process of forming the gap area AG and the support unit 130, the photoresist PR is configured to guide the partial removal of the buffer layer 130a under the light emitting elements 120. The gap area AG and the support unit 130 are formed by partially removing the buffer layer 130a under the light emitting elements 120 based on the photoresist PR. The photoresist PR may be formed as a photoresist pattern PRP by means of the exposure and development processes.

At this time, to partially remove the buffer layer 130a disposed below the light emitting elements 120, the photoresist PR may be configured with a double layered structure having different development rates. Specifically, the photoresist PR may include a first photoresist PR1 and a second photoresist PR2. The first photoresist PR1 may be formed of a material having a faster development rate, and for example, may be formed of a lift off resist (LOR). The second photoresist PR2 may be formed of a material having a slower development rate, and for example, may be formed of a positive photoresist.

The first photoresist PR1 may be formed in the plurality of openings OA. The first photoresist PR1 may be disposed to be in contact with the buffer layer 130a to be partially removed. Additionally, if there is any area where the buffer layer 130a to be removed is exposed in an outermost side surface of the epi layer EPI, the first photoresist PR1 may be formed to be in contact with that exposed side surface of the buffer layer 130a. For example, the buffer layer 130a whose side surface is exposed in a leftmost area of FIG. 5D is to be removed in the subsequent process. Thus, the first photoresist PR1 may be formed to be in contact with that side surface of the buffer layer 130a.

The second photoresist PR2 may be formed on the first photoresist PR1 so as to cover all the plurality of light emitting elements 120 and the first photoresist PR1. The second photoresist PR2 may be disposed so as to cover the overall substrate 110.

Next, a mask MASK is disposed on the photoresist PR and an exposure process is performed. The mask MASK may include a plurality of open areas MOA overlap the plurality of openings OA, respectively. Parts of the second photoresist PR2 exposed through the open areas MOA of the mask MASK are exposed to the light to change a chemical characteristic to be easily dissolved in a developer. At this time, a size of each of the open areas MOA is formed to be smaller than a size of the corresponding opening OA so that parts of the second photoresist PR2 covering or enclosing the side surfaces of the light emitting elements 120 are not exposed, and that only the other parts of the second photoresist PR2 overlapping the open area MOA are exposed.

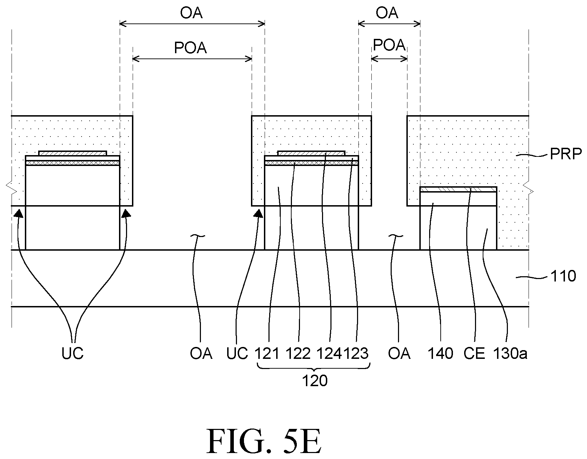

Next, as shown in FIG. 5E, the development process is performed to form the photoresist pattern PRP. A developer is applied to remove the exposed parts of the second photoresist PR2. The parts of the second photoresist PR2 overlapping the open areas MOA of the mask MASK are removed by the developer, and the remaining parts of the second photoresist PR2 are formed as the photoresist pattern PRP disposed so as to enclose or cover the side surfaces of the light emitting elements 120. The first photoresist PR1 exposed from the second photoresist PR2 is also removed together by the developer.

At this time, a development rate of the first photoresist PR1 may be faster than a development rate of the second photoresist PR2. Accordingly, during the development process, all of the first photoresist PR1 is removed, and undercut structures UC are formed between the second photoresist PR2 and the side surfaces of the buffer layer 130a. Further, the first photoresist PR1 is removed to expose the side surfaces of the buffer layer 130a.

Accordingly, the parts of the second photoresist PR2 overlapping the open areas MOA are removed by the development process, and the first photoresist PR1 is entirely removed to form the photoresist pattern PRP. The photoresist pattern PRP covers top surfaces and side surfaces of the light emitting elements 120 to protect the light emitting elements 120 from the etchant. The photoresist pattern PRP includes a plurality of photoresist openings POA overlapping the openings OA, respectively. Also, in the photoresist openings POA, the side surfaces of the photoresist pattern PRP may form undercut structures UC with the side surfaces of the buffer layer 130a, respectively. Further, a part of an outermost side surface of the photoresist pattern PRP may form an undercut structure UC with the corresponding side surface of the buffer layer 130a.

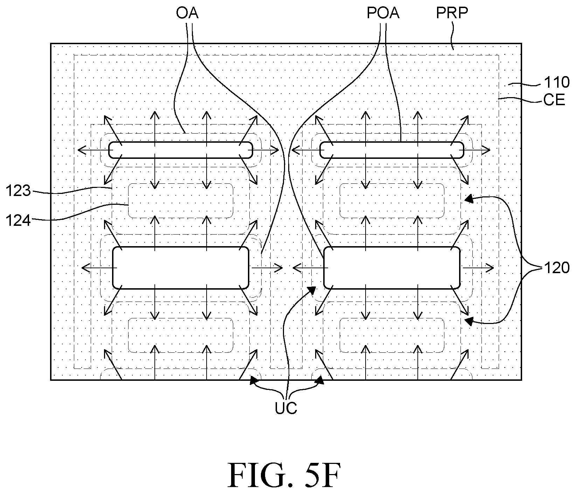

As illustrated in FIGs. 5E and 5F, the undercut structures are formed to be adjacent to the light emitting elements 120, respectively. For example, the undercut structures are disposed respectively along peripheries of the openings OA and are disposed respectively to be adjacent to the light emitting elements 120. Further, an undercut structure is also disposed adjacent to the light emitting element 120 in the outermost area of the substrate 110. For example, an undercut structure UC is formed in a lower side of the substrate 110 which is adjacent to the light emitting element 120 in FIG. 5F. Accordingly, the undercut structure UC is formed in the peripheral area of the plurality of openings OA and at a part of the outermost area of the substrate 110.

Next, as shown in FIGs. 5F and 5G, the etchant is applied to the undercut structure to etch the buffer layer 130a. The buffer layer 130a may be patterned by a wet etching method. For example, the wafer 100 may be immersed in the etchant to allow the etchant to be in contact with the portions of the side surfaces of the buffer layer 130a exposed from the photoresist pattern PRP. As the etchant, a solution which etches the buffer layer 130a may be used, and for example, a KOH solution may be used, but the etchant is not limited thereto. At this time, the light emitting elements 120 which are enclosed or covered by the photoresist pattern PRP may be protected from the etchant.

The KOH solution is an etchant which can etch a gallium nitride (GaN) layer and has a characteristic of etching a gallium nitride (GaN) layer in a horizontal direction but not in the vertical direction. Therefore, the buffer layer 130a which is exposed from the photoresist pattern PRP and is formed of gallium nitride (GaN) can be etched by the KOH solution in the horizontal direction. For example, as illustrated in FIG. 5G, the etching is performed in the horizontal direction and the width of the remaining buffer layer 130a located in the gap area AG below the light emitting element 120 is gradually reduced. Further, the buffer layer 130a is etched in the arrow directions as shown in FIGs. 5F and 5G.

The portions of the buffer layer 130a overlapping the light emitting elements 120 have a larger area exposed from the photoresist pattern PRP to be more exposed to the etchant and more rapidly etched. For example, a part of the buffer layer 130a located in the gap area AG and overlapping the corresponding light emitting element 120 have undercut structures on both sides and is simultaneously etched in opposite directions at both sides. Finally, the portions of the buffer layer 130a below the light emitting elements 120 are entirely removed to form the gap area AG. Further, the portions of the buffer layer 130a located below the common inspection electrode CE have a narrower area exposed from the photoresist pattern PRP to be less exposed to the etchant than the portions of the buffer layer 130a below the light emitting elements 120. Accordingly, at least parts of those portions of the buffer layer 130a located below the common inspection electrode CE remains to be configured as the support unit (or support) 130.

Finally, as illustrated in FIG. 5H, after completing the etching process of the buffer layer 130a, the photoresist pattern PRP is removed to complete the process of manufacturing the plurality of light emitting elements 120.

According to the method of manufacturing the light emitting elements 120 according to the example embodiment of the present disclosure, the buffer layer 130a is exposed from the photoresist pattern PRP to be selectively etched to form the gap area AG and the support unit 130. The first photoresist PR1 having a faster development rate is formed side surfaces of the buffer layers 130a, and the second photoresist PR2 having a slower development rate is formed between the light emitting elements 120. Therefore, by the exposure and development processes, the first photoresist PR1 is entirely removed, and only parts of the second photoresist PR2 covering the light emitting element 120 remain. The buffer layer 130a exposed from the photoresist pattern PRP is then etched to form the gap area AG below the light emitting elements 120 and the support unit 130 below the common inspection electrode CE and the connection unit (or connector) 140. Accordingly, according to the method of manufacturing the light emitting element(s) 120 according to the example embodiment of the present disclosure, the buffer layer 130a below the light emitting elements 120 and the connection unit 140 is partially or selectively etched to form the wafer 100 from which any defective light emitting element 120 can be easily removed.

Various example embodiments of the present disclosure can also be described as follows:

According to an aspect of the present disclosure, a wafer includes: a substrate, a plurality of light emitting elements above/on the substrate, a connector above the substrate and connected between the plurality of light emitting elements, and a support between the connector and the substrate, wherein the plurality of light emitting elements are spaced apart from the substrate.

According to an aspect of the present disclosure, a wafer includes: a substrate, a plurality of light emitting elements on the substrate and spaced apart therefrom, a connector (electrically) connecting at least some of the plurality of light emitting elements, and a support between the connector and the substrate.

The wafer according to any one of these aspects may include one or more of the following features:

The support may be supporting the connector on the substrate. The support may support the connector on the substrate with a space or gap therebetween. The support may space the connector from the substrate and/or may space the light emitting elements from the substrate. The support may have a grid structure with supporting parts and gap areas in between.

The connector may support the at least some of the plurality of light emitting elements. The connector may connect adjacent ones of the light emitting elements. The connector may be formed between adjacent ones of the light emitting elements. The connector may be integrally formed with a layer of the at least some of the plurality of light emitting elements. The connector may be made of semiconductor material.

The support may be on the substrate and may support the connector to form a porous area between the plurality of light emitting elements and the substrate. The porous area may be denoted as gap area or vice versa.

Each of the plurality of light emitting elements may include a first semiconductor layer connected to the connector. Each of the plurality of light emitting elements may include further an emission layer on the first semiconductor layer and a second semiconductor layer on the emission layer. Each of the plurality of light emitting elements may include an individual electrode. Each of the plurality of light emitting elements may include a first semiconductor layer connected to the connector, an emission layer on the first semiconductor layer, a second semiconductor layer on the emission layer, and an individual electrode on the second semiconductor layer.

The connector may be integrally formed with the first semiconductor layer and/or may have a smaller thickness than the first semiconductor layer. The connector may be made of the same material as the first semiconductor layer.

The connector may overlap the support and/or portions of the porous area (gap area). The connector may extend from the support into the gap area. The connector may have a larger width than the support. The connector and the plurality of light emitting elements may bridge over the gap area.

The wafer may further include a common inspection electrode on the connector. The common inspection electrode may be electrically connected to the plurality of light emitting elements through the connector. The common inspection electrode may be electrically connected to first semiconductor layer of each of the plurality of light emitting elements through the connector.

The wafer may further include an opening between two adjacent light emitting elements among the plurality of light emitting elements. The opening may be connected to the porous area (gap area).

According to an aspect of the present disclosure, a method of inspecting a plurality of light emitting elements on a wafer, in particular on a wafer according to any one of the herein described aspects and embodiments, includes: contacting the common inspection electrode and the individual electrodes of the plurality of light emitting elements respectively with a plurality of pin electrodes of a probe card.

The method of inspecting may further include applying a voltage to the common inspection electrode and the individual electrodes of the plurality of light emitting elements, and inspecting whether each of the plurality of light emitting elements emits light.

The method of inspecting may further include removing a defective light emitting element which does not emit light, among the plurality of light emitting elements.

The removing of a defective light emitting element may include laser cutting the connector, e.g. cutting the connector by irradiating a portion of the connector adjacent and connected to the defective light emitting element with laser.

The plurality of pin electrodes may include a plurality of first pin electrodes configured to come into contact with the plurality of light emitting elements (in particular with the individual electrodes thereof), respectively. The plurality of pin electrodes may include at least one second pin electrode configured to come into contact with the common inspection electrode. The plurality of pin electrodes may include a plurality of first pin electrodes configured to be in contact with the plurality of light emitting elements, respectively, and one second pin electrode configured to be in contact with the common inspection electrode. The first pin electrodes and the second pin electrodes may protrude with different lengths from the probe card.

According to an aspect of the present disclosure, a method of manufacturing a plurality of light emitting elements includes: forming an epi layer including a buffer layer on a substrate, forming the plurality of light emitting elements and a connector by etching the epi layer, and forming a porous area (gap area) under the plurality of light emitting elements and forming a support under the connector by etching the buffer layer.

According to an aspect of the present disclosure, a method of manufacturing a wafer having a plurality of light emitting elements includes: forming an epi layer including a buffer layer on a substrate, forming the plurality of light emitting elements and a connector connecting the plurality of light emitting elements by etching the epi layer, and forming a gap area between the plurality of light emitting elements and the substrate, and forming a support under the connector by etching the buffer layer.

The method of manufacturing a wafer and/or a plurality of light emitting elements may include at least one of the following features:

The wafer to be manufactured may be a wafer according to any one of the herein described aspects and embodiments.

The epi layer may include a first semiconductor material layer on the buffer layer. The epi layer may include an emission material layer on the first semiconductor material layer. The epi layer may include a second semiconductor material layer on the emission material layer.

The forming of the plurality of light emitting elements and/or of the connector may include forming a plurality of second semiconductor layers by etching the second semiconductor material layer, forming a plurality of emission layers by etching the emission material layer, and forming a plurality of first semiconductor layers and/or the connector by etching the first semiconductor material layer. The connector may be integral with and connect the plurality of first semiconductor layers to each other.

The forming of the porous area (gap area) and/or the support may include forming a plurality of openings in the connector and the buffer layer in areas between the plurality of light emitting elements. The forming of the porous area (gap area) and/or the support may include forming a photoresist pattern on the substrate, and etching portions of the buffer layer to form the porous area and the support. The photoresist pattern may be formed on the substrate, e.g. in the openings, and/or on the light emitting elements and/or on the connector.

The forming of the photoresist pattern may include forming a first photoresist in the plurality of openings. The forming of the photoresist pattern may include forming a second photoresist on the first photoresist, the plurality of light emitting elements, and the connector. The forming of the photoresist pattern may include disposing a mask including a plurality of open areas on the second photoresist, and removing parts of the second photoresist exposed through the plurality of open areas of the mask and removing all the first photoresist to form the photoresist pattern.

The photoresist pattern may cover top surfaces and/or side surfaces of the plurality of light emitting elements and/or may expose side surfaces of the buffer layer.

The first photoresist may include a material having a faster development rate than a material of the second photoresist.

Each of the plurality of open areas of the mask may overlap a corresponding one of the plurality of openings and/or may have a smaller width than the corresponding one of the plurality of openings.

The etching of the buffer layer may include wet-etching the buffer layer by applying an etchant on exposed surfaces the buffer layer. The etchant may be a solution which etches the buffer layer in a horizontal direction.

The etching of the buffer layer may include etching a part of the buffer layer overlapping the plurality of light emitting elements to form the porous area. The etching of the buffer layer may include partially etching a part of the buffer layer overlapping the connector to form the support with a remaining part of the buffer layer.

Although the example embodiments of the present disclosure have been described in detail above with reference to the accompanying drawings, the present disclosure is not limited thereto and may be embodied in many different forms without departing from the technical concept of the present disclosure. Therefore, the example embodiments of the present disclosure are provided for illustrative purposes only and are not intended to limit the technical concept of the present disclosure. The scope of the technical concept of the present disclosure is not limited thereto. Therefore, it should be understood that the above-described example embodiments are illustrative in all aspects and do not limit the present disclosure. All the technical concepts in the equivalent scope of the present disclosure should be construed as falling within the scope of the present disclosure.

## Claims

1. A wafer (100), comprising:
a substrate (110);
a plurality of light emitting elements (120) on the substrate (110) and spaced apart from the substrate (110);
a connector (140) supporting and/or electrically connecting the plurality of light emitting elements (120); and
a support (130) between the connector (1140) and the substrate (110) for supporting the connector (140) on the substrate (110).

2. The wafer according to claim 1, wherein the support (130) supports the connector (140) to form a gap area (AG) between the plurality of light emitting elements (120) and the substrate (110).

3. The wafer according to claim 2, further comprising:
an opening (OA) between two adjacent light emitting elements (120) among the plurality of light emitting elements (120),
wherein the opening (OA) is connected to the gap area (AG).

4. The wafer according to any one of the preceding claims, wherein each of the plurality of light emitting elements (120) includes:
a first semiconductor layer (121) connected to the connector (140);
an emission layer (122) on the first semiconductor layer (121); and
a second semiconductor layer (123) on the emission layer (122).

5. The wafer according to claim 4, wherein the connector (140) is integrally formed with the first semiconductor layer (121) and/or is made of the same material as the first semiconductor layer (121) and/or has a smaller thickness than the first semiconductor layer (121).

6. The wafer according to any one of the preceding claims, wherein:
the connector (140) overlaps the support (130) and/or has a larger width than the support (130) .

7. The wafer according to any one of the preceding claims, further comprising:
a common inspection electrode (CE) on the connector (140) and electrically connected to the plurality of light emitting elements (120) through the connector (140);
wherein each of the plurality of light emitting elements (120) includes an individual electrode (124).

8. A method of inspecting the plurality of light emitting elements on the wafer of claim 7, the method comprising:
contacting the common inspection electrode (CE) and the individual electrodes (124) of the plurality of light emitting elements (120) respectively with a plurality of pin electrodes (PIN) of a probe card (PC).

9. The method of claim 8, further comprising:
applying a voltage to the common inspection electrode (CE) and the individual electrodes (124) of the plurality of light emitting elements (120); and
inspecting whether each of the plurality of light emitting elements (120) emits light.

10. The method of claim 9, further comprising:
removing a defective light emitting element which does not emit light, among the plurality of light emitting elements (120) by laser cutting the connector (140) adjacent and/or connected to the defective light emitting element.

11. A method of manufacturing a wafer (100) with a plurality of light emitting elements (120), the method comprising:
forming an epi layer (EPI) including a buffer layer (130a) on a substrate (110);
forming the plurality of light emitting elements (120) and a connector (140) connecting the plurality of light emitting elements (120) by etching the epi layer (EPI); and
forming a gap area (AG) between the plurality of light emitting elements and the substrate (110) and forming a support (130) under the connector (140) by etching the buffer layer (130a).

12. The method of claim 11, wherein the epi layer (EPI) includes:
a first semiconductor material layer (121a) on the buffer layer (130a);
an emission material layer (122a) on the first semiconductor material layer (121a); and
a second semiconductor material layer (123a) on the emission material layer (122a), and
wherein the forming of the plurality of light emitting elements (120) and the connector (140) includes:
forming a plurality of second semiconductor layers (123) by etching the second semiconductor material layer (124a);
forming a plurality of emission layers (122) by etching the emission material layer (122a); and
forming a plurality of first semiconductor layers (121) and the connector (140) by etching the first semiconductor material layer (121a), the connector (140) being integral with and connecting the plurality of first semiconductor layers (121) to each other.

13. The method of claim 11 or 12, wherein the forming of the gap area (AG) and the support (130) includes:
forming a plurality of openings (OA) in the connector (140) and the buffer layer (130a) in areas between the plurality of light emitting elements (120);
forming a photoresist pattern (PRP) on the substrate (110); and
etching portions of the buffer layer (130a) to form the gap area (GA) and the support (130).

14. The method of claim 13, wherein the forming of the photoresist pattern (PR) includes:
forming a first photoresist (PR1) in the plurality of openings (OA);
forming a second photoresist (PR2) on the first photoresist (PR1), the plurality of light emitting elements (120), and the connector (140);
disposing a mask (MASK) including a plurality of open areas (MOA) on the second photoresist (PR2); and
removing parts of the second photoresist (PR2) exposed through the plurality of open areas (MOA) of the mask (MASK) and removing all the first photoresist (PR1) to form the photoresist pattern (PRP), the photoresist pattern (PRP) covering top surfaces and side surfaces of the plurality of light emitting elements (120) and exposing side surfaces of the buffer layer (130a).

15. The method of claim 13 or 14, wherein the etching of the buffer layer (130a) includes wet-etching the buffer layer (130a) by applying an etchant on exposed surfaces the buffer layer (130a), the etchant being a solution which etches the buffer layer (130a) in a horizontal direction; and/or
wherein the etching of the buffer layer (130a) includes:
etching a part of the buffer layer (130a) overlapping the plurality of light emitting elements (120) to form the gap area (AG); and
partially etching a part of the buffer layer (130a) overlapping the connector (140) to form the support (130) with a remaining part of the buffer layer (130a).
